# EUROPÄISCHE PATENTSCHRIFT

(11) **EP 1 529 217 B1**
(45) Veröffentlichungstag und Bekanntmachung des Hinweises auf die Patenterteilung: **03.11.2010**
(21) Anmeldenummer: 03709653.4
(22) Anmeldetag: 25.02.2003
(51) Int. Cl.: G01P 15/08, B81B 3/00

(54) **MIKROMECHANISCHES BAUELEMENT**
MICROMECHANICAL COMPONENT
COMPOSANT MICROMECANIQUE

(30) Priorität: 02.08.2002 DE 10235370
(43) Veröffentlichungstag der Anmeldung: 11.05.2005
(73) Patentinhaber: ROBERT BOSCH GMBH, 70442 Stuttgart (DE)
(72) Erfinder: ULLMANN, Dirk, 72762 Reutlingen (DE)
(86) Internationale Anmeldenummer: PCT/DE2003/000591
(87) Internationale Veröffentlichungsnummer: WO 2004/019048

(56) Entgegenhaltungen:
- DE-A- 10 012 960
- DE-A- 19 825 298
- US-A- 4 346 597
- US-A- 4 346 597
- US-A- 5 140 155
- PATENT ABSTRACTS OF JAPAN vol. 1997, no. 09, 30. September 1997 (1997-09-30) -& JP 09 127151 A (MURATA MFG CO LTD), 16. Mai 1997 (1997-05-16)

## Beschreibung

Die Erfindung betrifft ein mikromechanisches Bauelement, insbesondere Beschleunigungssensor, mit einem Substrat, mindestens einer Federeinrichtung und mindestens einer seismischen Masse, wobei die Federeinrichtung mit einem ersten Ende mit dem Substrat und an einem zweiten Ende mit der Masse verbunden ist, und wobei die Steifigkeit (Federkonstante) der Federeinrichtung so ausgelegt ist, dass durch eine Beschleunigung relativ zum Substrat, insbesondere parallel zu einer Oberfläche des Substrats, eine Bewegung der Masse relativ zum Substrat verursachbar ist.

Ein derartiges mikromechanisches Bauelement ist bereits aus der DE 100 12 960 A1 bekannt.

Obwohl auf beliebige mikromechanische Bauelemente und Strukturen, insbesondere Sensoren und Aktuatoren, anwendbar, werden die vorliegende Erfindung sowie die ihr zugrunde liegende Problematik in Bezug auf einen in der Technologie der Silizium-Oberflächenmikromechanik (OMM) herstellbaren mikromechanischen Beschleunigungssensor erläutert.

Beschleunigungssensoren, und insbesondere mikromechanische Beschleunigungssensoren in der Technologie der Oberflächen- bzw. Volumenmikromechanik, gewinnen immer größere Marktsegmente im Kraftfahrzeugausstattungsbereich und ersetzen in zunehmendem Maße die bisher üblichen piezoelektrischen Beschleunigungssensoren.

Die bekannten mikromechanischen Beschleunigungssensoren funktionieren üblicherweise derart, dass die federnd gelagerte seismische Masseneinrichtung, welche durch eine externe Beschleunigung in mindestens eine Richtung auslenkbar ist, bei Auslenkung eine Kapazitätsänderung an einer damit verbundenen Differentialkondensatoreinrichtung bewirkt, die ein Maß für die Beschleunigung ist. Eine Differentialkondensatoreinrichtung mit einer zur Oberfläche des Substrats parallelen Kammstruktur aus bewegten und festen Elektroden ist in der genannten Offenlegungsschrift beschrieben. Die Auslenkung kann auch anhand einer anderen geeigneten Messmethode nachgewiesen werden.

Die Empfindlichkeit solcher bekannter mikromechanischer Beschleunigungssensoren für die Messgröße Beschleunigung kann gegenwärtig im Wesentlichen nur durch die Steifigkeit der Federlagerung der seismischen Masse eingestellt werden, also durch deren vorab zu wählende Federkonstante. Eine hohe Empfindlichkeit bedeutet dabei jedoch, dass die linearen Rückstellkräfte der Federn klein sind, so dass das Bauelement aufgrund seiner entsprechend geringen Belastbarkeit nur als Nieder-g-Sensor einsetzbar ist. Für Beschleunigungssensoren, die in einem Bereich mit höherer maximaler Beschleunigung, beispielsweise 50 g (g = Erdbeschleunigung) oder 100 g eingesetzt werden sollen, ist deshalb die Federeinrichtung von vornherein mit einer höheren Steifigkeit (Federkonstante) auszulegen.

Aufgrund des linearen Zusammenhangs zwischen Beschleunigung und Auslenkung korrespondiert bei einer derartigen, "harten" Feder eine große Beschleunigung allerdings mit einer kleinen Auslenkung, demnach auch mit einer geringeren Empfindlichkeit des Beschleunigungssensors. Für die praktische Anwendung besteht der Wunsch nach Sensoren, die gleichzeitig eine hohe Auflösung im unteren Messbereich und einen großen, das heißt bis zu großen maximalen Beschleunigungen reichenden, Messbereich aufweisen; bisher muss sich der Anwender jedoch entweder für eine bestimmte Bereichs- bzw. Empfindlichkeits-Klasse entscheiden oder - als aufwendige Alternative - mehrere Sensoren verschiedener Bereichsklassen gleichzeitig einsetzen.

Die vorab zu wählenden g-Bereichsklassen bedingen auch den herstellungstechnischen Nachteil, dass für verschiedene g-Bereichsklassen jeweils verschiedene Layouts erforderlich sind. In der oben genannten Offenlegungsschrift wird deshalb ein gattungsgemäßer Beschleunigungssensor vorgeschlagen, bei dem die Federsteifigkeit auch nach Herstellung - beim Vormessen oder Endmessen - noch extern einstellbar ist, so dass ein einziges Layout bzw. Design für einen breiten Bereich von Steifigkeiten verwendbar ist. Zu diesem Zweck sind Teile der Federeinrichtung entarretierbar bzw. arretierbar ausgeführt, so dass eine gewünschte effektive Federkonstante insbesondere durch Wirkung eines Messstroms oder eines extern steuerbaren Magnetfeldes auf einen Trennbereich einstellbar ist. Einmal vorgenommene Einstellungen sind allenfalls durch eine erneute externe Einstellprozedur änderbar.

Die Schrift US 4346597 A lehrt einen Beschleunigungssensor mit zwei verschiedenen Empfindlichkeitsbereichen. Der Übergang in den Bereich mit anderer Sensorempfindlichkeit vollzieht sich beim Auftreffen eines Federelements auf einer festen Anschlagstruktur.

Die Schrift US 5140155 A offenbart einen Beschleunigungssensor mit Federelement mit variabler Dicke.

Die Schriften JP 09 127151 A und DE 19825298 A zeigen Beschleunigungssensoren mit aus mehreren aneinander anschlagfähigen Biegefedern bestehenden Federelementen.

Aufgabe der vorliegenden Erfindung ist es, einen mikromechanischen Beschleunigungssensor der eingangs genannten Art anzugeben, der - ohne externe Beeinflussung zu erfordern - gleichzeitig eine hohe Auflösung im unteren Messbereich und einen großen, das heißt bis zu großen maximalen Beschleunigungen reichenden, Messbereich aufweist.

Diese Aufgabe wird erfindungsgemäß dadurch gelöst, dass die Federeinrichtung für ein intrinsisch nichtlineares Verhalten entsprechend einer progressiven Feder-Kennlinie ausgelegt ist, in der eine größere Beschleunigung mindestens bereichsweise mit einer größeren Steifigkeit (Federkonstante) verknüpft ist, so dass das Bauelement mit dieser nichtlinearen Federeinrichtung bei größerer Beschleunigung mindestens bereichsweise eine geringere Empfindlichkeit aufweist.

Der nichtlineare Beschleunigungssensor mit seiner degressiven Sensor-Kennlinie (entsprechend der progressiven Kennlinie seiner Federeinrichtung) liefert eine über den Messbereich der Beschleunigung mindestens bereichsweise oder sogar stetig abfallende Empfindlichkeit. Abgesehen von der unterschiedlichen Empfindlichkeit kann erfindungsgemäß somit die Funktion von zwei verschiedenen g-Bereichsklassen-Sensoren mit einem einzigen nichtlinearen Bauelement abgedeckt werden.

Erfindungemäß ist die Federeinrichtung durch zwei Biegefederelemente gebildet, die so angeordnet sind, dass die Beweglichkeit des ersten Biegefederelementes gegenüber dem Substrat durch einen elastischen Federanschlag eingeschränkt aber nicht begrenzt ist, wobei der Federanschlag durch das zweite Biegefederelement selbst gebildet ist. Bei zunehmender Beschleunigung weist die Empfindlichkeit des Bauelementes dadurch zunächst einen konstanten, der Federkonstante des ersten Biegefederelementes entsprechenden Wert auf, während die Empfindlichkeit ab Erreichen des Federanschlags - aufgrund der Mitnahme des zweiten Biegefederelementes durch das erste Biegefederelement bei der weiteren Auslenkung - einen wiederum konstanten, jedoch, einer höheren Federkonstante entsprechenden höheren Wert aufweist. Auf diese einfache Weise lässt sich ein Bauelement realisieren, dessen Sensor-Kennlinie aus einem ersten linearen Teilbereich mit höherer Steigung (Empfindlichkeit) und, "mit Knick" daran anschließend, einem zweiten linearen Teilbereich mit niedrigerer Steigung (Empfindlichkeit) zusammengesetzt ist. Die intrinsische Nichtlinearität ist in diesem Fall also durch das selbstgesteuerte additive Zusammenwirken zweier Federelemente implementierbar.

Ein Ausführungsbeispiel der Erfindung ist in den Figuren der Zeichnung dargestellt und in der nachfolgenden Beschreibung näher erläutert. Es zeigt
Figur 1 in einem schematischen Diagramm die Bauelement-Kennlinie mit der Abhängigkeit des Ausgangssignals von der Beschleunigung für ein Bauelement der Ausführungsform gemäß Figur 2 und Figur 3,
Figur 2 und Figur 3 eine partielle Aufsicht auf zwei verschiedene Funktionszustände eines Beschleunigungssensors gemäß einer ersten Ausführungsform der vorliegenden Erfindung,

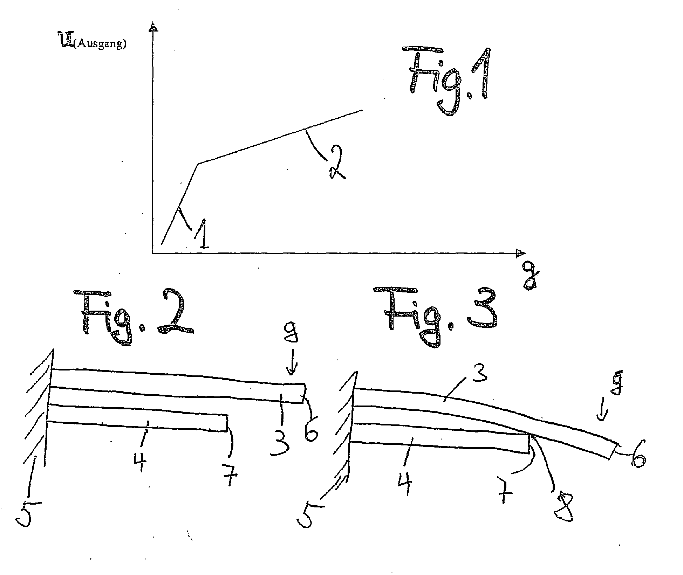

Figur 1 zeigt den nichtlinearen Verlauf der Sensor-Kennlinie 1 und 2, wie sie beispielsweise durch die Biegefederelemente gemäß Figur 2 und Figur 3 realisierbar ist. In diesem einfachen Fall einer nichtlinearen Kennlinie ist diese aus einem ersten konstanten Teilbereich 1 mit höherer Steigung und einem zweiten Teilbereich 2 mit einem ebenfalls konstanten, jedoch weniger steilen Verlauf unstetig, mit einem " Knick ", zusammengesetzt, so dass die Sensor-Kennlinie insgesamt einen degressiven Verlauf hat.

Der Zusammenhang der in Figur 1 dargestellten Sensor-Kennlinie 1 und 2 mit der nicht dargestellten Feder-Kennlinie besteht darin, dass gemäß dem Hookschen Gesetz die lineare Rückstellkraft der Federeinrichtung der Auslenkung direkt proportional ist, so dass das gemäß der Auslenkung der Masse gemessene, in Figur 1 dargestellte, Sensor-Ausgangssignal U vom Kehrwert der Federkonstante abhängt. Die größere Steigung der Kennlinie 1 im unteren Messbereich, d. h. bei kleinen Beschleunigungswerten g, entspricht demnach einer hohen Empfindlichkeit des mikromechanischen Bauelementes und korrespondiert mit einer "weichen" Feder, also einer Feder mit geringer Steifigkeit bzw. Federkonstante. Umgekehrt entspricht die geringere, aber über diesen Teilbereich wiederum konstante, Empfindlichkeit des Beschleunigungssensors im zweiten Teilbereich 2. der Sensor-Kennlinie, d. h. bei großen Beschleunigungswerten g, einer "harten" Feder, also einer Feder mit größerer Steifigkeit bzw. Federkonstante.

Figur 2 zeigt, dass die Biegefederelemente 3 und 4 gemäß der Ausführungsform der Erfindung jeweils eine längliche Form aufweisen und mit ihren ersten Enden jeweils am Bauelement-Substrat 5 verankert sind. Die Richtung der angreifenden Beschleunigung g (parallel zur Oberfläche des Substrats 5) ist in den Figuren 2 und 3 jeweils durch einen Pfeil angedeutet. Die Biegefederelemente 3 und 4 sind, parallel zueinander, quer (insbesondere senkrecht) zur Richtung der Beschleunigung g angeordnet, wobei das zweite, mit der Masse verbundene Ende 6 des ersten Biegefederelementes 3 das zweite, über das anschlagende erste Biegefederelement 3 mittelbar mit der (nicht dargestellten) Masse verbindbare, Ende 7 des zweiten Biegefederelementes 4 überragt.

Wenn, wie im Funktionszustand gemäß Figur 3 angedeutet, eine Beschleunigung der Masse eine Biegung des ersten Biegefederelementes 3 bis hin zum zweiten Biegefederelement 4 verursacht, so erfolgt ein Anschlag 8 der dem zweiten Biegefederelement 4 zugewandten Oberfläche des ersten Biegefederelementes 3 am zweiten Ende 7 des zweiten Biegefederelementes 4. Bei weiterer Beschleunigung und Deformierung des ersten Biegefederelementes 3 nimmt dieses das zweite Biegefederelement 4 bei der weiteren Biegung.mit, wobei die zusätzliche Federkonstante des zweiten Biegefederelementes 4 ins Spiel kommt. Insbesondere durch Wahl der Länge (und damit der Steifigkeiten) der Biegefederelemente 3 und 4, der Länge des "Überstands" des ersten über das zweite Biegefederelement, sowie ihres Abstandes zueinander, lassen sich Wünsche hinsichtlich der Art des nichtlinearen Biegeverhaltens in einem relativ weiten Bereich realisieren.

Obwohl die vorliegende Erfindung vorstehend anhand eines bevorzugten Ausführungsbeispiels beschrieben wurde, ist sie darauf nicht beschränkt, sondern auf vielfältige Weise modifizierbar. Beispielsweise kann sie bei einem Beschleunigungssensor, bei dem, wie in der Offenlegungsschrift DE 199 59 707 A 1 beschrieben, die Schwungmasse um eine senkrecht zur Substratoberfläche liegende Drehachse und um mindestens eine parallel zur Substratoberfläche liegende Drehachse elastisch aus ihrer Ruhelage auslenkbar ist, eingesetzt werden. Ebenso ist ein Einsatz bei einem Beschleunigungssensor denkbar, bei dem zwei verschiedene Massen wippenartig senkrecht zur Substratoberfläche auslenkbar sind, wobei die Aufhängung durch eine Torsionsfeder gegeben ist.

## Patentansprüche

1. Mikromechanischer Beschleunigungssensor, mit einem Substrat **(5),**
mindestens einer Federeinrichtung (**3, 4**,) und mindestens einer seismischen Masse, wobei die Federeinrichtung (**3, 4**,) mit einem ersten Ende mit dem Substrat (**5**) und an einem zweiten Ende (**6**) mit der Masse verbunden ist, und
wobei die Steifigkeit bzw, Federkonstante der Federeinrichtung (**3, 4**) so ausgelegt ist, dass durch eine Beschleunigung (g) relativ zum Substrat **(5),** insbesondere parallel zu einer Oberfläche des Substrats **(5),** eine Bewegung der Masse relativ zum Substrat (**5**) verursachbar ist,
wobei die Federeinrichtung (**3**, **4**) für ein intrinsisch nichtlineares Verhalten entsprechend einer progressiven Feder-Kennlinie ausgelegt ist, in der eine größere Beschleunigung (g) mindestens bereichsweise mit einer größeren Steifigkeit bzw. Federkonstante verknüpft ist, so dass das Bauelement mit dieser nichtlinearen Federeinrichtung (**3, 4**) bei größerer Beschleunigung (g) mindestens bereichsweise eine geringere Empfindlichkeit aufweist,
- wobei die Federeinrichtung durch zwei Biegefederelemente **(3, 4)** gebildet ist, die so angeordnet sind, dass die Beweglichkeit des ersten Biegefederelementes (**3**) gegenüber, dem Substrat (**5**) durch einen elastischen Federanschlag (**8**) eingeschränkt aber nicht begrenzt ist,
- wobei der Federanschlag (**8**) durch das zweite Biegefederelement (**4**) selbst gebildet ist,
- so dass bel zunehmender Beschleunigung (g) die Empfindlichkeit des Beschleunigungssonsors zunächst einen konstanten, der Federkonstante des ersten Biegefederelementes (3) entsprechenden Wert aufweist, während die Empfindlichkeit ab Erreichen des Federanschlags (**8**) **-** aufgrund der Mitnahme des zweiten Biegefederelementes (**4**) durch das erste Biegefederelement (3) bei der weiteren Auslenkung - einen wiederum konstanten, jedoch einer höheren Federkonstante entsprechenden höheren Wert aufweist,
**dadurch gekennzeichnet,**
- **dass** die Biegefederelemente **(3, 4)** jeweils eine längliche Form aufweisen,
- **dass** die Biegefederelemente (**3, 4**), parallel zueinander, quer zur Oberflächenrichtung des substrats angeordnet sind, wobei das zweite, mit der Masse verbundene Ende (6) des ersten Biegefederelementes (3) das zweite, über das anschlagende erste Biegefederelement **(3)** mittelbar mit der Masse verbindbare, Ende (7) des zweiten Biegefederelementes **(4)** überragt,
- so dass durch eine von der Beschleunigung (g) der Masse verursachte Biegung des ersten Biegefederelementes **(3)** bis hin zum zweiten Biegefederelement **(4)** ein Anschlag **(8)** der dem zweiten Biegefederelement **(4)** zugewandten Oberfläche des ersten Biegefederelementes **(3)** am zweiten Ende **(7)** des zweiten Biegefederelementes **(4)** bewirkt ist.

## Claims

1. Micromechanical acceleration sensor having a substrate (5), at least one spring device (3, 4) and at least one seismic mass, a first end of the spring device (3, 4) being connected to the substrate (5) and a second end (6) of the spring device (3, 4) being connected to the mass, and the rigidity or spring constant E of the spring device (3, 4) being designed in such a manner that a movement of the mass relative to the substrate (5) can be caused by an acceleration (g) relative to the substrate (5), in particular parallel to a surface of the substrate (5),
- the spring device (3, 4) being designed for an intrinsically non-linear behaviour in accordance with a progressive spring characteristic in which a greater acceleration (g) is linked, at least in regions, to a greater rigidity or spring constant E, with the result that the component having this non-linear spring device (3, 4) has a lower sensitivity, at least in regions, in the case of greater acceleration (g),
- the spring device being formed by two bending spring elements (3, 4) which are arranged in such a manner that the movability of the first bending spring element (3) with respect to the substrate (5) is restricted but not delimited by an elastic spring stop (8),
- the spring stop (8) being formed by the second bending spring element (4) itself,
- with the result that, with increasing acceleration (g), the sensitivity of the acceleration sensor first of all has a constant value corresponding to the spring constant of the first bending spring element (3), whereas, after reaching the spring stop (8), the sensitivity has a higher value which is again constant but corresponds to a higher spring constant on account of the fact that the second bending spring element (4) is taken along by the first bending spring element (3) during the further deflection,
**characterized**
- **in that** the bending spring elements (3, 4) each have an elongate shape,
- **in that** the bending spring elements (3, 4) are arranged parallel to one another and transversely with respect to the surface direction of the substrate, the second end (6) of the first bending spring element (3) which is connected to the mass projecting beyond the second end (7) of the second bending spring element (4) which can be indirectly connected to the mass via the first bending spring element (3) which provides the stop,
- with the result that that surface of the first bending spring element (3) which faces the second bending spring element (4) is stopped (8) at the second end (7) of the second bending spring element (4) as a result of bending of the first bending spring element (3) as far as the second bending spring element (4), which bending is caused by the acceleration (g) of the mass.

## Revendications

1. Capteur d'accélération micromécanique, comprenant un substrat (5), au moins un dispositif de ressort (3, 4) et au moins une masse sismique, le dispositif de ressort (3, 4) étant connecté par une première extrémité au substrat (5) et par une deuxième extrémité (6) à la masse, et la rigidité ou la constante de ressort du dispositif de ressort (3, 4) étant conçue de telle sorte qu'un déplacement de la masse par rapport au substrat (5) puisse être provoqué par une accélération (g) par rapport au substrat (5), notamment parallèlement à une surface du substrat (5),
- le dispositif de ressort (3, 4) étant conçu pour un comportement intrinsèquement non linéaire correspondant à une caractéristique de ressort progressive, dans laquelle une plus grande accélération (g) est associée au moins en partie à une plus grande rigidité ou constante de ressort, de sorte que le composant avec ce dispositif de ressort non linéaire (3, 4) présente, pour une plus grande accélération (g), au moins en partie une plus faible sensibilité,
- le dispositif de ressort étant formé par deux éléments de ressort à flexion (3, 4) qui sont disposés de telle sorte que la mobilité du premier élément de ressort à flexion (3) par rapport au substrat (5) soit confinée par une butée de ressort élastique (8) mais ne soit pas limitée,
- la butée de ressort (8) étant formée par le deuxième élément de ressort à flexion (4) lui-même,
- de sorte que dans le cas d'une accélération (g) croissante, la sensibilité du capteur d'accélération présente d'abord une valeur constante correspondant à la constante de ressort du premier élément de ressort à flexion (3) tandis que la sensibilité une fois la butée de ressort (8) atteinte - du fait de l'entraînement du deuxième élément de ressort à flexion (4) par le premier élément de ressort à flexion (3) lors de la déviation supplémentaire - présente une valeur à nouveau constante mais supérieure correspondant à une constante de ressort supérieure,
**caractérisé en ce que**
- les éléments de ressort à flexion (3, 4) présentent à chaque fois une forme allongée,
- les éléments de ressort à flexion (3, 4) sont disposés parallèlement l'un à l'autre, transversalement à la direction de la surface du substrat, la deuxième extrémité (6) du premier élément de ressort à flexion (3) connectée à la masse dépassant la deuxième extrémité (7) du deuxième élément de ressort à flexion (4) pouvant être connectée à la masse de manière indirecte par le biais du premier élément de ressort à flexion sollicitant (3),
- de sorte que par une flexion du premier élément de ressort à flexion (3) provoquée par l'accélération (g) de la masse, jusqu'au deuxième élément de ressort à flexion (4), une venue en butée (8) de la surface du premier élément de ressort à flexion (3) tournée vers le deuxième élément de ressort à flexion (4) contre la deuxième extrémité (7) du deuxième élément de ressort à flexion (4) soit provoquée.
